# EUROPEAN PATENT APPLICATION

(11) **EP 4 712 111 A1**
(43) Date of publication of application: **18.03.2026**
(21) Application number: 25197280.8
(22) Date of filing: 21.08.2025
(51) Int. Cl.: H01C 7/12, H01R 13/66, H02H 9/04, G01R 31/28, H01C 1/14, H01C 1/02, H01T 4/04

(54) **SURGE PROTECTION DEVICE, TRANSMITTER, SURGE PROTECTION SYSTEM, AND INTERCOMMUNICATION TRANSMITTER**

(30) Priority: 13.09.2024 JP 2024159270
(71) Applicant: Yokogawa Electric Corporation, Tokyo 180-8750 (JP)
(72) Inventor: KIDO, Ryosuke, Musashino-shi, Tokyo, 180-8750, (JP)
(74) Representative: Winter, Brandl - Partnerschaft mbB

(57) **Abstract**

A surge protection device (1) is mounted on a transmitter (100). A cable that sends a signal received from an external device is connected to terminal block screw portions (12, 13). The connector (23) is detachable with respect to a connector component provided in the transmitter (100), and outputs an input signal received from each of the terminal block screw portions (12, 13) to the connector component. The surge protection element (21, 22) absorbs a surge electric current in a case where a surge voltage is applied from the terminal block screw portions (12, 13) to the connector component. The terminal connector portion (11) is connected to the terminal block screw portions (12, 13) via the surge protection element (21, 22).

## Description

### FIELD

The present invention relates to a surge protection device, a transmitter, a surge protection system, and an intercommunication transmitter.

### BACKGROUND

Conventionally, in process control performed in various plants using petroleum, petrochemicals, chemical substances, gas, or the like, a field device, such as a pressure transmission device, is used in order for a controller to stably control processes. Control and management of the plant are performed by a plant control system on the basis of information obtained by the field device.

In general, the field device includes a power supply terminal, and receives a supply of electrical power needed for an operation as a result of a power supply cable being connected to the power supply terminal. Furthermore, in a case of a two-wire transmitter, the power supply cable also functions as an electric current output signal cable that varies in the range between 4 mA to 20 mA.

The power supply cable may sometimes contain an instantaneous and large abnormal voltage referred to as a surge voltage due to a lightning strike or a high voltage facility. A surge protection device (also referred to as a lightning arrester, an arrestor, a surge absorber, transient protection device, etc.) is used in order to protect the field device from the surge voltage.

In some cases, the surge protection device may be packaged on a circuit board of the field device, may be mounted on the field device as a surge protection module, or the like. The surge protection device that is used as the surge protection module is constituted to have a configuration in which the surge protection device includes a pair of positive and negative terminals for a connection to the power supply terminals provided in the field device that is to be protected, and a surge protection element is connected between these terminals.

As the surge protection element, a metal oxide varistor, an avalanche diode, a gas-filled discharge tube, a surge protection thyristor, and the like are known. Furthermore, a filter function or the like for a noise removal is sometimes installed in the surge protection device. Some of the surge protection device is soldered to a housing of the field device, and, in this case, it is difficult to replace the surge protection device.

In addition, as for a lighting apparatus, there is a device having a replaceable module that is used for surge protection. Furthermore, as for a centrifugal compressor, there is a device having a function of detecting a compressor surge. Furthermore, as a device having mounted thereon a temperature sensor, there is a device in which a surge protection device is installed in a replaceable manner.
Patent Literature 1: U.S. Patent Application Publication No. 2010/0127625
Patent Literature 2: U.S. Patent Application Publication No. 2017/0284410
Patent Literature 3: Chinese Patent of Utility Model No. 203385492

However, in a case where a surge voltage has occurred, the surge protection device blocks a leakage of the surge voltage to the field device, but at that time, the surge protection element is damaged and is being degraded. In the surge protection device provided in the conventional field device, it is difficult to detect the degradation of the surge protection element, and it is thus difficult to appropriately determine a replacement period. Similarly, it is difficult for the lighting apparatus on which the module that is used for surge protection is mounted, for the centrifugal compressor that has a function of detecting a compressor surge, and for the temperature sensor in which the surge protection device is installed in a replaceable manner to detect the degradation of the surge protection element. As a result of this, it has been difficult to improve the reliability of the field device, such as a transmitter.

Furthermore, in a case of the surge protection device that is soldered to the housing of the field device, if degradation occurs in the surge protection device, there is a need to replace the entirety of the housing of the field device, so that the replacement is not easy, and it is thus difficult to improve the reliability of the field device, such as the transmitter. In addition, in a case where the entirety of the housing of the field device is replaced, an operational cost is increased. Furthermore, the structure of each of the lighting apparatus and the centrifugal compressor is different from the structure of the field device, so that it is difficult to apply the structure to the surge protection device provided in the field device without any change.

One aspect of an embodiment of the present invention improves reliability of a transmitter by detecting degradation of a surge protection device.

### SUMMARY

It is an object of the present invention to at least partially solve the problems in the conventional technology.

According to an aspect of an embodiment, a surge protection device that is mounted on a transmitter, the surge protection device includes, a signal terminal to which a cable that sends a signal output from an external device is connected, a connector that is detachable with respect to a connector component provided in the transmitter, and that outputs an input signal received from the signal terminal to the connector component, a surge protection element that absorbs a surge electric current in a case where a surge voltage is applied from the signal terminal to the connector component, and a terminal connector portion that is connected to the signal terminal via the surge protection element.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a perspective view of a pressure/differential pressure transmitter;
FIG. 2 is a perspective view of the surge protection device;
FIG. 3 is a front view of the surge protection device on a terminal block side;
FIG. 4 is a front view of the surge protection device on a circuit board side;
FIG. 5 is a diagram illustrating the surge protection device in a state in which a circuit board has been removed;
FIG. 6 is a diagram illustrating a part of wiring of the surge protection device;
FIG. 7 is a diagram illustrating a measurement principle of a tester;
FIG. 8 is a diagram illustrating a circuit that is used for self-diagnosis and that is mounted on a surge protection device according to a second embodiment; and
FIG. 9 is a configuration diagram illustrating the outline of a transmitter with a type of intercommunication according to a fifth embodiment.

### DESCRIPTION OF EMBODIMENTS

In the following, preferred embodiments of a transmitter will be explained with reference to the accompanying drawings. Furthermore, by assigning the same reference numerals to the same components, overlapping descriptions thereof will be appropriately omitted. In addition, each of the embodiments may be used in any appropriate combination as long as they do not conflict with each other.

### First Embodiment

### Overall configuration

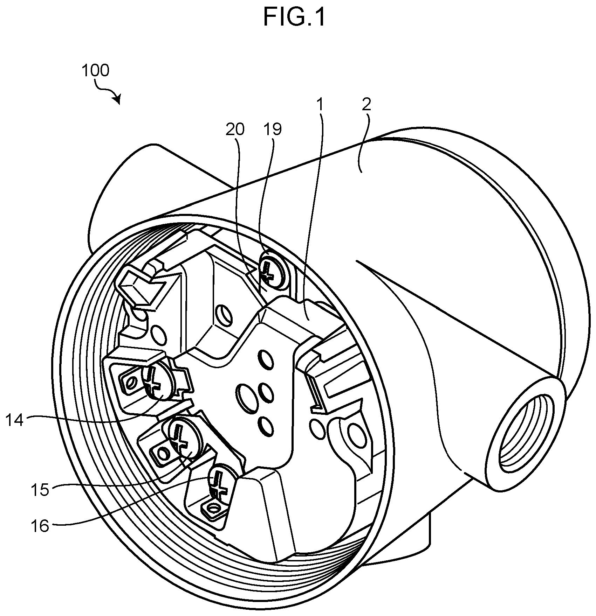

FIG. 1 is a perspective view of a pressure/differential pressure transmitter. A pressure/differential pressure transmitter 100 is one example of a field device (transmitter). A housing 2 of the pressure/differential pressure transmitter 100 includes a terminal and a circuit that are partitioned by a wall and are separated each other. The terminal is a visible open space that is opened toward the outside in FIG. 1. In the pressure/differential pressure transmitter 100, a surge protection device 1 is arranged in a terminal that is located on the other side of the space of the interior portion partitioned by the wall.

An internal circuit that includes a resistance and an amplifier and that is used for pressure/differential pressure transmission is arranged on the circuit side. A connector component (not illustrated) that sends a signal to the internal circuit is provided on the terminal side of the wall that is a partition between the terminal and the circuit included in the pressure/differential pressure transmitter 100.

The pressure/differential pressure transmitter 100 receives an input of the signal sent from a higher-level process control device via the surge protection device 1. Then, the pressure/differential pressure transmitter 100 sends a signal that indicates a measurement result generated by the internal circuit on the basis of the received signal to an external device, so that the pressure/differential pressure transmitter 100 notifies an external device of a control instruction received from the higher-level process control device.

The surge protection device 1 has a shape that fits in the interior portion of the pressure/differential pressure transmitter 100. Furthermore, the surge protection device 1 includes screws 14 to 16 that fix, to a screw portion, an input/output terminal that is used to receive an input signal to be input to the pressure/differential pressure transmitter 100 and that is used to send an output signal received from the pressure/differential pressure transmitter 100. The wiring extending from, for example, the higher-level process control device is connected by the screws 14 to 16 and the screw portion.

Furthermore, the surge protection device 1 includes a circuit board 20 in a direction toward the space of the interior portion included in the pressure/differential pressure transmitter 100. A grounding terminal 19 is provided on the circuit board 20 at a position away from the screw portion in which each of the screws 14 to 16 is connected. Furthermore, both of the connecting terminal that is included in the circuit board 20 and a connector component that is provided on the wall of the interior portion included in the pressure/differential pressure transmitter 100 are detachable. As a result of the connecting terminal included in the circuit board 20 being connected to the connector component, the input/output terminal included in the surge protection device 1 and the internal circuit included in the pressure/differential pressure transmitter 100 are connected.

The surge protection device 1 receives, by the input/output terminal, an input of a power supply that is supplied from the higher-level process control device or an input of the signal of the field communication sent from the higher-level process control device. Then, the surge protection device 1 sends the signal received from the higher-level process control device to the internal circuit that is included in the pressure/differential pressure transmitter 100 via the connecting terminal that is included in the circuit board 20 and via the connector component that is connected to the subject connecting terminal.

Furthermore, in a case where a surge occurs and the surge protection device 1 receives an input of a surge electric current, the surge protection device 1 causes the surge protection element to absorb the surge electric current, and flows the surge electric current to a grounding wire via the grounding terminal 19. As a result of this, it is possible to protect the circuit provided in the pressure/differential pressure transmitter 100 from the surge electric current by preventing the surge electric current from flowing through the wiring of the interior portion included in the pressure/differential pressure transmitter 100.

### Details of surge protection device

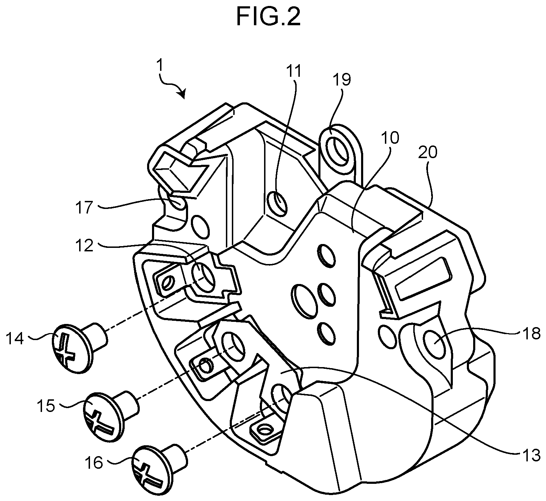

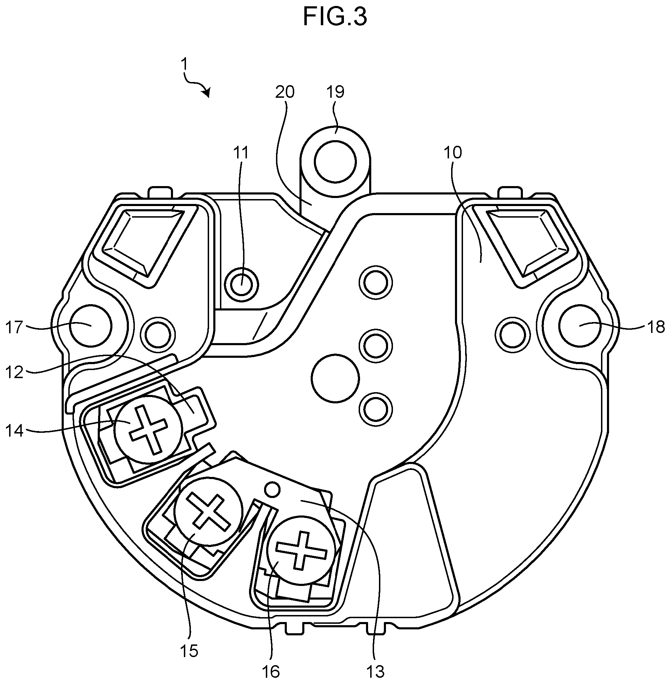

FIG. 2 is a perspective view of the surge protection device. FIG. 2 illustrates a state in which the surge protection device 1 that is in the state illustrated in FIG. 1 is taken out from the partitioned space of the interior portion provided in the pressure/differential pressure transmitter 100, and then, the screws 14 to 16 have been removed. Furthermore, FIG. 3 is a front view of the surge protection device on the terminal block side.

As illustrated in FIGS. 2 and 3, the surge protection device 1 includes a main body case 10. Furthermore, the surge protection device 1 includes the screws 14 to 16 that are detachable, the grounding terminal 19, and the circuit board 20. The main body case 10 and the circuit board 20 correspond to the housing of the surge protection device 1.

The surge protection device 1 includes terminal block screw portions 12 and 13 on the main body case 10. As illustrated in FIG. 2, two screw portions are actually present on the terminal block screw portion 13, but here, the two screw portions are collectively referred to as the terminal block screw portion 13. Here, there may be a case in which the terminal block screw portion 13 is not used in accordance with the type of the device on which the surge protection device 1 is mounted. Furthermore, the surge protection device 1 includes a terminal connector portion 11. Furthermore, the surge protection device 1 includes screw fixing portions 17 and 18 on the main body case 10.

The screw 14 is screwed into and fixed to the terminal block screw portion 12 while sandwiching the wiring that extends from the external device. Furthermore, the screws 15 and 16 are screwed into and fixed to the respective two screw portions provided in the terminal block screw portion 13 while sandwiching the wiring that extends from the external device. Here, there may be a case in which both of the screw 16 and the terminal block screw portion 13 disposed on the screw 16 side are not used in accordance with the type of the device on which the surge protection device 1 is mounted. Furthermore, the main body case 10 is fixed to the terminal portion provided in the housing 2 of the pressure/differential pressure transmitter 100 by the screw fixing portions 17 and 18.

Here, each of a combination of the terminal block screw portion 12 and the screw 14, and a combination of the terminal block screw portion 13 and the screws 15 and 16 corresponds to one example of a "signal terminal". Moreover, a cable for sending a signal that is output from the external device, such as a higher-level process device, is connected to each of the signal terminals. Both of the combination of the terminal block screw portion 12 and the screw 14, and the combination of the terminal block screw portion 13 and the screws 15 are arranged on the main body case 10 so as to be exposed to the outside. Then, the signal terminal sends the signal output from the external device, such as the higher-level process device, to the internal circuit provided in the pressure/differential pressure transmitter 100 via a connector 23 and the connector component of the pressure/differential pressure transmitter 100.

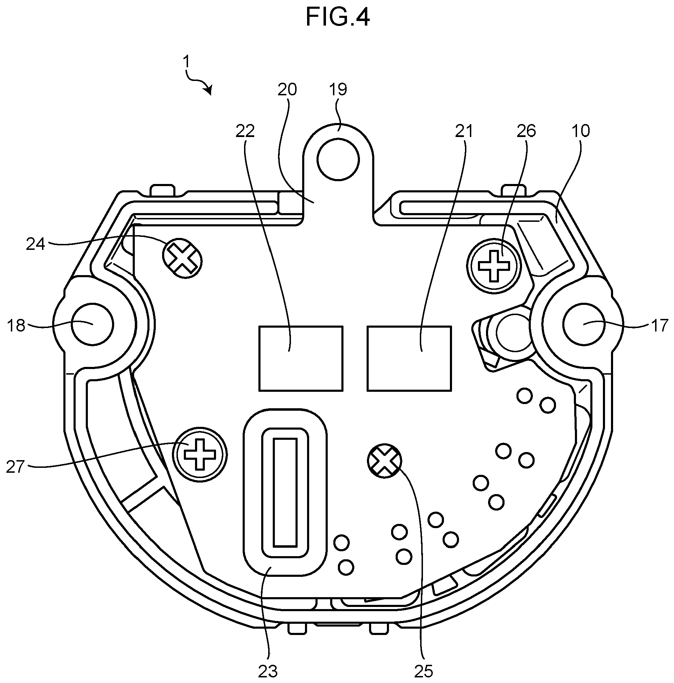

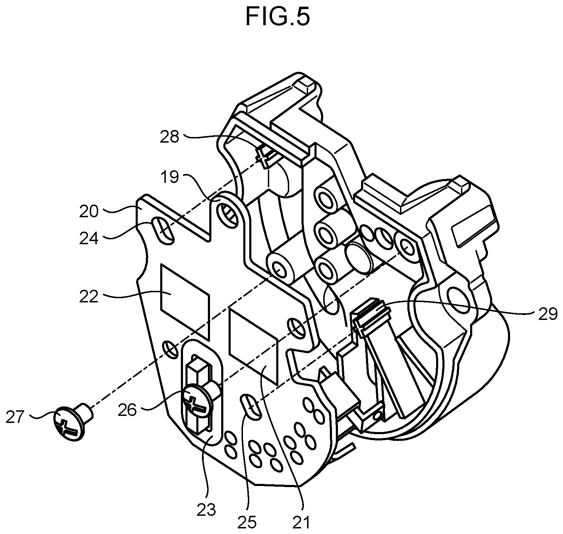

FIG. 4 is a front view of the surge protection device on the circuit board side. FIG. 5 is a diagram illustrating the surge protection device that is in a state in which the circuit board has been removed.

As illustrated in FIG. 4, the surge protection device 1 includes, on the circuit board 20, a positive side varistor 21, a negative side varistor 22, the connector 23 that is a connecting terminal included in the circuit board 20, and positioning holes 24 and 25. The connector 23 is arranged on the surface facing toward the outside of the circuit board 20, and is exposed to the outside from the main body case 10 that is the housing. Furthermore, the circuit board 20 is attached to and fixed to the main body case 10 by tapping screws 26 and 27.

The positive side varistor 21 does not flow an electric current in a case where the voltage to be applied is a positive voltage and is equal to or less than a predetermined value, and flows a high electric current in a case where the voltage to be applied is in a positive direction and is larger than the predetermined value. In contrast, the negative side varistor 22 has a high resistance value in a case where the voltage to be applied is a negative voltage and an absolute value of the voltage is equal to or less than the predetermined value, and, in contrast, the negative side varistor 22 flows a high electric current in a case where the absolute value of the voltage is larger than the predetermined value. In a case where a surge with a high voltage has occurred on the positive side, the positive side varistor 21 absorbs the surge electric current. Furthermore, in a case a surge with a high voltage has occurred on the negative side, the negative side varistor 22 absorbs the surge electric current. In a case where a voltage that is equal to or higher than the maximum allowable voltage is applied, degradation occurs in both of the positive side varistor 21 and the negative side varistor 22 at the applied time.

Here, in this case, the positive side varistor 21 and the negative side varistor 22 are arranged on the circuit board 20 at a position opposite the pressure/differential pressure transmitter 100, but the arrangement location is not limited to this. For example, the positive side varistor 21 and the negative side varistor 22 may be arranged on the surface of the circuit board 20 that faces the interior portion and that is located on a side opposite to a side facing the pressure/differential pressure transmitter 100.

Each of the positive side varistor 21 and the negative side varistor 22 corresponds to one example of the "surge protection element". In other words, the surge protection element includes the positive side varistor 21 that absorbs the surge electric current generated in a case where the surge voltage of the positive side has been applied, and the negative side varistor 22 that absorbs the surge electric current generated in a case where the surge voltage of the negative side has been applied. Furthermore, the surge protection element absorbs the surge electric current in a case where the surge voltage has been applied from the signal terminal with respect to the connector component. The positive side varistor 21 and the negative side varistor 22 are arranged in the interior portion of the main body case 10 that is the housing or arranged on the outer surface thereof.

As illustrated in FIG. 5, as a result of positioning portions 28 and 29 that are provided on the inner side of the main body case 10 being inserted into the positioning holes 24 and 25 of the circuit board 20, the circuit board 20 is arranged at predetermined position with respect to the main body case 10. Then, the circuit board 20 is fixed as a result of the tapping screws 26 and 27 being screwed into the main body case 10.

In a case where the main body case 10 is installed with respect to the housing 2 of the pressure/differential pressure transmitter 100, the connector 23 provided on the circuit board 20 is located at the position opposite the connector component that is arranged on the partition wall that partitions the terminal and the circuit included in the pressure/differential pressure transmitter 100. Then, when the main body case 10 has been installed in the housing 2 of the pressure/differential pressure transmitter 100, the connector 23 provided on the circuit board 20 is connected to the connector component of the pressure/differential pressure transmitter 100.

Here, both of the connector 23 provided on the circuit board 20 and the connector component provided in the pressure/differential pressure transmitter 100 are detachable, so that the main body case 10 in which the circuit board 20 has been installed becomes detachable with respect to the housing 2 of the pressure/differential pressure transmitter 100. In other words, the surge protection device 1 can be easily detachable with respect to the pressure/differential pressure transmitter 100.

As described above, the connector 23 is connected to the internal circuit that is built into the pressure/differential pressure transmitter 100. Moreover, the connector 23 is detachable with respect to the connector component of the pressure/differential pressure transmitter 100, and outputs the input signal received from the signal terminal to the connector component. Furthermore, when the main body case 10 that is the housing is mounted on the pressure/differential pressure transmitter 100, the connector 23 is connected to the connector component, and when the main body case 10 that is the housing is removed from the pressure/differential pressure transmitter 100, the connector 23 is removed from the connector component.

The terminal connector portion 11 is arranged so as to be exposed from the main body case 10 to the outside. The terminal connector portion 11 is connected to the signal terminal via the positive side varistor 21 and the negative side varistor 22 that are the surge protection elements.

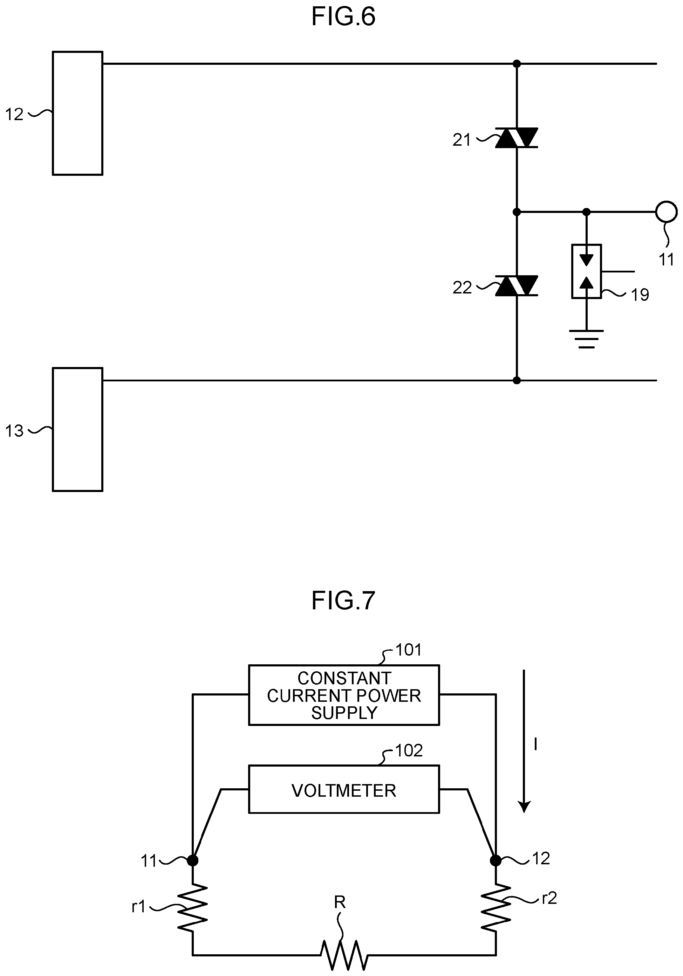

FIG. 6 is a diagram illustrating a part of the wiring of the surge protection device. The terminal block screw portion 12 is connected to the internal circuit of the pressure/differential pressure transmitter 100 via the connector 23 that is provided on the circuit board 20 and via the connector component that is disposed on the pressure/differential pressure transmitter 100 side connected to the connector 23. The wiring extending from the terminal block screw portion 12 branched off in the middle of the path and is connected to one end of the positive side varistor 21. The other end of the positive side varistor 21 is connected to the terminal connector portion 11. The grounding terminal 19 is arranged in the middle of the path that connects the positive side varistor 21 and the terminal connector portion 11.

Similarly, the terminal block screw portion 13 is connected to the internal circuit of the pressure/differential pressure transmitter 100 via the connector 23 provided on the circuit board 20 and via the connector component provided on the pressure/differential pressure transmitter 100 side that is connected to the connector 23. The wiring extending from the terminal block screw portion 13 branched off in the middle of the path and is connected to one end of the negative side varistor 22. The other end of the negative side varistor 22 is connected to the terminal connector portion 11. The grounding terminal 19 is arranged in the middle of the path that connects the negative side varistor 22 and the terminal connector portion 11.

As described above, both of the positive side varistor 21 and the negative side varistor 22 that are the signal terminals and the terminal connector portion 11 are connected such that the resistance value of each of the positive side varistor 21 and the negative side varistor 22 is able to be measured by using a terminal measurement method performed by using a tester. Furthermore, one end of each of the positive side varistor 21 and the negative side varistor 22 is connected to the signal terminal, and the other end of each of the positive side varistor 21 and the negative side varistor 22 is connected to a grounding wire by way of the grounding terminal 19 that is mounted on the arrestor. Furthermore, the terminal connector portion 11 is connected to the wiring that is branched off from the wiring that connects the positive side varistor 21 and the negative side varistor 22 to the grounding wire.

with this wiring, in a case where a surge voltage is applied to the terminal block screw portion 12 or 13, a surge electric current is absorbed by the positive side varistor 21 or the negative side varistor 22 in accordance with the polar character of the positive side varistor 21 or the negative side varistor 22, so that it is possible to reduce the impact on the circuit disposed in the interior portion of the pressure/differential pressure transmitter 100.

### Degradation detection method

Degradation of the surge protection device 1 is caused by degradation of each of the positive side varistor 21 and the negative side varistor 22. Therefore, in the surge protection device 1 according to the present embodiment, a user determines the degradation of each of the positive side varistor 21 and the negative side varistor 22 in the following procedure, and detects the degradation of the surge protection device 1.

The user has a constant current power supply, and performs the following processes by using a tester (Tester) that includes a voltmeter that measures a voltage on the basis of a potential difference generated due to a load applied when an electric current flows.

The user connects one end of the tester to the terminal connector portion 11 that is illustrated in FIG. 3, and connects the other end of the tester to the terminal block screw portion 12, and then, flows a constant electric current between the terminal connector portion 11 and the terminal block screw portion 12. Then, the user measures the voltage between the terminal connector portion 11 and the terminal block screw portion 12 by using the tester.

FIG. 7 is a diagram illustrating the measurement principle of the tester. Here, a case of a degradation determination performed on the positive side varistor 21 will be described. A resistance R denotes a resistance of the positive side varistor 21. Furthermore, each of the resistances r1 and r2 denotes a wiring resistance.

The user performs a common two-terminal measurement method using the tester. In other words, as illustrated in FIG. 7, a constant electric current I generated in a constant current power supply 101 provided in the tester is allowed to flow through a load with the resistance R of the positive side varistor 21 and the resistances r1 and r2 that are the wiring resistances. Then, the user reads the voltage between the terminal connector portion 11 and the terminal block screw portion 12 by using a voltmeter 102 provided in the tester. In this case, in addition to the resistance R of the varistor, the resistance of the load includes the resistances r1 and r2 that are the wiring resistances, but, as compared with the resistance R, the effects of the resistances r1 and r2 is small, so that the user is able to determine the degradation of the positive side varistor 21 by using the two-terminal measurement method as described above.

Here, in the present embodiment, a case in which the two-terminal measurement method is used has been described, but it is also able to perform degradation detection by using a four-terminal measurement method, and, in this case, it is possible to remove the effect of the wiring resistance, which makes it possible to perform the degradation detection with higher accuracy.

The positive side varistor 21 enters a short circuit mode at the time of failure caused by the degradation, and the resistance value becomes small. Accordingly, the user determines that the positive side varistor 21 has been degraded in a case where the resistance value obtained from the measured voltage is smaller than the predetermined value. As a result of this, the user is able to detect the degradation of the surge protection device 1.

Furthermore, the user connects one end of the tester to the terminal connector portion 11 that is illustrated in FIG. 3, and connects the other end of the terminal block screw portion 13, and then, flows the constant electric current between the the terminal connector portion 11 and the terminal block screw portion 13. Then, the user measures the voltage between the terminal connector portion 11 and the terminal block screw portion 13 by using the tester. As a result of this, the user is able to determine the degradation of the negative side varistor 22 on the basis of the resistance value obtained from the measured voltage.

Similarly, the negative side varistor 22 also enters the short circuit mode at the time of failure caused by the degradation, and the resistance value becomes small. Accordingly, the user determines that the negative side varistor 22 has been degraded in a case where the resistance value obtained from the measured voltage is smaller than the predetermined value. As a result of this, the user is able to detect the degradation of the surge protection device 1.

Here, the system that includes the pressure/differential pressure transmitter 100, the surge protection device 1, and the tester that is used by the user correspond to one example of a "surge protection system".

### Replacement method

As described above, the surge protection device 1 is easily detachable with respect to the pressure/differential pressure transmitter 100. Accordingly, in a case where the user detects the degradation of the surge protection device 1, the user detaches the surge protection device 1 from the housing 2 of the pressure/differential pressure transmitter 100 by loosening the screw fixing portions 17 and 18. Then, the user arranges the new surge protection device 1 in the partitioned space provided in the interior portion of the pressure/differential pressure transmitter 100, and fixes the new surge protection device 1 to the housing 2 by using the screw fixing portions 17 and 18. As described above, the surge protection device 1 is able to be easily replaced in a case where the surge protection device 1 has been degraded.

Here, in the above description, the pressure/differential pressure transmitter 100 with a two-wire type has been described as an example of the transmission device, but the use of the surge protection device 1 according to the present embodiment is not limited to the pressure/differential pressure transmitter 100 with the two-wire type. For example, the surge protection device 1 according to the present embodiment may be used for a two-wire field device, such as a temperature transmitter, a vortex flowmeter, or a pH meter, or may be used for a four-wire field device that receives a power supply from a commercial power supply, or the like, such as an electromagnetic flow meter, a Coriolis flow meter, or an ultrasonic flow meter.

### Effects

As described above, the surge protection device 1 according to the present embodiment includes the terminal connector portion 11 that is used to determine the degradation. Moreover, the user is able to determine the degradation of the surge protection device 1 by using the tester with respect to the terminal connector portion 11 and the terminal block screw portions 12 and 13.

Furthermore, the housing 2 of the pressure/differential pressure transmitter 100 includes the terminal and the circuit that are separated by a wall. Among the conventional field devices, in some cases, a surge protection device is arranged on the circuit side. Furthermore, in the conventional field device, in order to connect the terminal and the circuit, the terminal and the circuit need to be connected by passing through the wall of the housing. As a result of this, conventionally, cheap soldering has been performed in consideration of the waterproof property or the noise performance. The circuit is arranged at the back of the terminal and it is thus difficult to directly access the circuit. Therefore, in a case where the surge protection device is arranged in the circuit, it is difficult to replace the surge protection device. Furthermore, in also a case where the surge protection device is arranged in the terminal, in the conventional field device, wiring of the surge protection device is usually welded, so that a replacement of the surge protection device has been difficult.

On the other hand, the surge protection device 1 according to the present embodiment is arranged on the terminal side provided in the pressure/differential pressure transmitter 100, and is also constituted such that the connection with the internal circuit is detachable by using the connector 23, so that it is possible to easily replace the surge protection device 1 according to the present embodiment in a case of degradation.

As described above, by using the surge protection device 1 according to the present embodiment, the user is able to easily find the replacement period that is difficult for the user to know, and is able to replace the surge protection device 1 in an appropriate period. In other words, the user is able to replace the surge protection device 1 before the surge protection device 1 is completely damaged, so that it is possible to improve the reliability of the transmitter. In addition, as a whole, it is possible to implement a cost reduction in an operation of the transmitter.

### Second Embodiment

In the following, a second embodiment will be described. The surge protection device 1 according to the present embodiment automatically performs impedance measurement of the circuit that includes the terminal block screw portion 13 and the terminal connector portion 11, and performs a self-diagnosis on the degradation by recognizing the leakage electric current. In the description below, a description of the same function as that of each of the units described above in the first embodiment will be omitted.

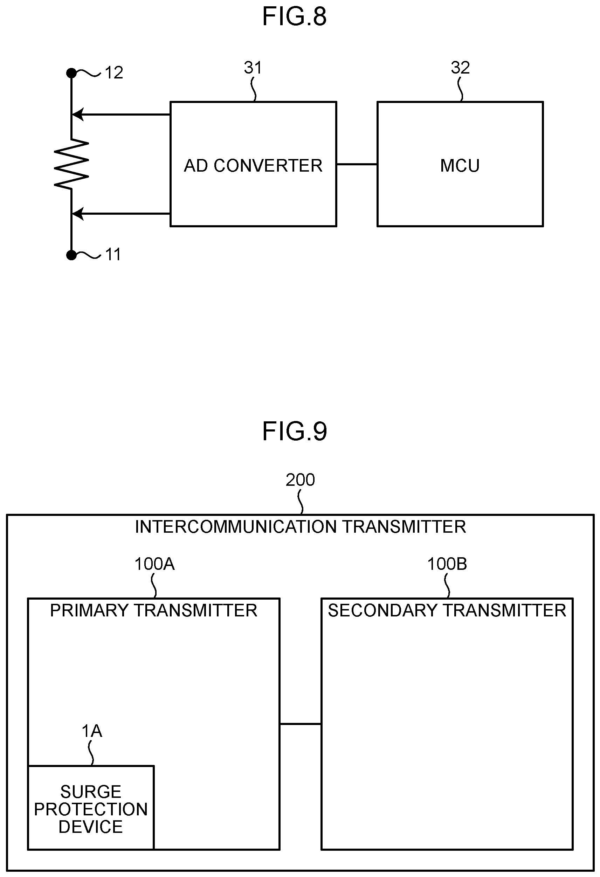

FIG. 8 is a diagram illustrating a circuit that is used for self-diagnosis and that is mounted on a surge protection device according to a second embodiment. The surge protection device 1 according to the present embodiment includes, as illustrated in FIG. 8, an analog digital (AD) converter 31 and a micro controller unit (MCU) 32.

The AD converter 31 is connected to both ends of the resistance disposed between, for example, the terminal block screw portion 12 and the terminal connector portion 11. In detail, the AD converter 31 is connected to both ends of the positive side varistor 21 that is illustrated in FIG. 6.

As a result of a leakage electric current flowing from the resistance between the terminal block screw portion 12 and the terminal connector portion 11 illustrated in FIG. 8, the AD converter 31 is able to acquire a voltage between both ends of the subject resistance. The AD converter 31 converts the voltage between both ends of the resistance between the terminal block screw portion 13 and the terminal connector portion 11 to a digital signal, and outputs the digital signal to the MCU 32.

The MCU 32 is connected to the AD converter 31. The MCU 32 acquires, from the AD converter 31, an input of the voltage between both ends of the resistance that has been converted to the digital signal and that is disposed between the terminal block screw portion 12 and the terminal connector portion 11. Then, the MCU 32 measures an impedance of the resistance between the terminal block screw portion 12 and the terminal connector portion 11, and then identifies the leakage electric current. After that, the MCU 32 measures the resistance value between the terminal block screw portion 12 and the terminal connector portion 11 on the basis of the leakage electric current and the impedance.

The MCU 32 determines the degradation of the positive side varistor 21 on the basis of the measured resistance value. The MCU 32 detects the degradation of the surge protection device 1 from the positive side varistor 21 and the determination result of the degradation. In a case where the MCU 32 detects the degradation of the surge protection device 1, the MCU 32 notifies the user of detection of the degradation. For example, the MCU 32 may notify of the detection of the degradation by activating a warning lamp (not illustrated) that is provided in the surge protection device 1, or may send a message indicating the detection of the degradation to a terminal device that is used by the user.

Here, in the present embodiment, the description has been made by using the resistance between the terminal block screw portion 12 and the terminal connector portion 11, that is, the resistance of the positive side varistor 21, as an example, but the same applies to the resistance between the terminal block screw portion 13 and the terminal connector portion 11, that is, the resistance of the negative side varistor 22.

The MCU 32 corresponds to one example of the control unit. The MCU 32 measures the resistance value of the surge protection element from the leakage electric current flowing between the signal terminal and the terminal connector portion 11, and detects the degradation of the surge protection element on the basis of the measured resistance value of the surge protection element.

### Effects

As described above, the surge protection device 1 according to the present embodiment is able to automatically detect the own degradation by using the leakage electric current flowing between the terminal block screw portion 13 and the terminal connector portion 11. As a result of this, the user is able to promptly identify the replacement period, and is able to replace the surge protection device 1 in an appropriate period. Therefore, this makes it possible to improve the reliability of the field device.

### Third Embodiment

In the following, a third embodiment will be described. The surge protection device 1 according to the present embodiment uses the MCU 32 described above in the second embodiment, and presumes a remaining durability count from each of the resistance values of the positive side varistor 21 and the negative side varistor 22. The remaining durability count mentioned here is information indicating how many more times it is possible to absorb a surge electric current and protect the pressure/differential pressure transmitter 100. In the description below, a description of the same function as that of each of the units described above in the second embodiment will be omitted. In the following, the positive side varistor 21 will be described as an example.

The MCU 32 has in advance information indicating how much the resistance value of the positive side varistor 21 changes with a single surge. In practical, the magnitude of the change in a single surge depends on energy of the surge, but, in the present embodiment, for example, the magnitude of the change in a single surge is determined on the basis of the common voltage and the common electric current of the standard requirements.

The MCU 32 obtains the resistance value of the positive side varistor 21 from the resistance value between the terminal block screw portion 12 and the terminal connector portion 11. Then, the MCU 32 presumes how many more times the positive side varistor 21 is able to withstand the surge, that is, the remaining durability count, on the basis of the information on the current resistance value of the positive side varistor 21 and the magnitude of the change in a single lightning surge. After that, the MCU 32 notifies the user of the remaining durability count of the positive side varistor 21.

Here, in the present embodiment, the description has been made by using the positive side varistor 21 as an example, the MCU 32 is also able to presume the remaining durability count in the same manner as for the resistance of the negative side varistor 22. As described above, the MCU 32 that is the control unit has in advance information on an amount of change in the resistance value of the surge protection element indicated by a single surge, and presumes the remaining durability count of the surge protection element on the basis of the presumed resistance value of the surge protection element and the amount of change in the resistance value of the surge protection element.

### Effects

As described above, the surge protection device 1 according to the present embodiment is able to automatically detect the remaining durability count of each of the positive side varistor 21 and the negative side varistor 22 by using the leakage electric current flowing between the terminal block screw portion 13 and the terminal connector portion 11. As a result of this, the user is able to promptly identify the replacement period, and is able to replace the surge protection device 1 in an appropriate period. Therefore, this makes it possible to improve the reliability of the field device.

### Fourth Embodiment

In the following, a fourth embodiment will be described. The surge protection device 1 according to the present embodiment uses the MCU 32 described above in the third embodiment, presumes a degradation period in the future, and automatically determines the purchase period of the spare part to be replaced. In the following, the positive side varistor 21 will be described as an example. In the description below, a description of the same function as that of each of the units described above in the third embodiment will be omitted. In the following, the positive side varistor 21 will be described as an example.

The MCU 32 has in advance information indicating how much the resistance value of the positive side varistor 21 changes with a single surge and information on operation time of the surge protection device 1. Furthermore, the MCU 32 counts the number of times of the surges flowing through the positive side varistor 21, and holds the number of surges currently experienced in the positive side varistor 21.

The MCU 32 presumes the remaining durability count of the positive side varistor 21 on the basis of the information on the current resistance value of the positive side varistor 21 and the information on the magnitude of the change in a single surge. Then, the MCU 32 obtains a frequency of occurrence of the surge on the basis of the operation time of the surge protection device 1 and the number of surges currently experienced in the positive side varistor 21.

Then, the MCU 32 calculates an occurrence period of the degradation of the positive side varistor 21 by using a frequency of occurrence of the surge and using the remaining durability count of the positive side varistor 21. After that, the MCU 32 determines the purchase period of the spare part of the positive side varistor 21 for the replacement on the basis of the calculated occurrence period of the degradation. Then, the MCU 32 notifies the user of the purchase period of the spare part of the positive side varistor 21. In addition, by connecting the MCU 32 to a server or the like disposed in the providing source of the parts by using a network, the MCU 32 may automatically purchase the spare part of the positive side varistor 21 from the providing source in the purchase period of the spare part of the positive side varistor 21.

As described above, the MCU 32 that is the control unit counts the number of surge occurrences, and presumes the degradation period of the surge protection element on the basis of the number of occurrences, the operation time, and the remaining durability count. Furthermore, the MCU 32 determines the purchase period of the spare part of the surge protection element in accordance with the presumed degradation period.

### Effects

As described above, the surge protection device 1 according to the present embodiment is able to determine the purchase period of the spare part by presuming the occurrence period of the degradation. As a result of this, the user is able to procure the spare part in advance, and is able to replace the surge protection device 1 in an appropriate period. Therefore, this makes it possible to improve the reliability of the field device.

### Fifth Embodiment

In the following, a fifth embodiment will be described. FIG. 9 is a configuration diagram illustrating the outline of a transmitter with a type of intercommunication according to a fifth embodiment. the surge protection device 1 according to the present embodiment is mounted on an intercommunication transmitter 200.

The intercommunication transmitter 200 includes, as illustrated in FIG. 9, a primary transmitter 100A and a secondary transmitter 100B. The intercommunication transmitter 200 is able to handle various kinds of physical quantities of measurement objects. For example, the intercommunication transmitter 200 is a differential pressure transmitter. In a description below, the intercommunication transmitter 200 will be descried by using the differential pressure transmitter as an example.

The primary transmitter 100A and the secondary transmitter 100B are connected by a cable used for intercommunication. Both of the primary transmitter 100A and the secondary transmitter 100B are able to send and receive data to and from via the cable that is used for the intercommunication. The primary transmitter 100A is arranged on the high pressure side of the pressure that is generated by the measurement object. The secondary transmitter 100B is arranged on a low pressure side of the pressure that is generated by the measurement object.

The primary transmitter 100A acquires the pressure measured by the secondary transmitter 100B, and outputs a signal corresponding to the differential pressure between the pressure that has been measured by the primary transmitter 100A and the pressure that has been measured by the secondary transmitter 100B.

A surge protection device 1A is mounted n the primary transmitter 100A. In the surge protection device 1A, similarly to the surge protection device 1 described above, the terminal block screw portions 12 and 13, and the terminal connector portion 11 are arranged.

The user connects one end of the tester to the terminal connector portion 11 included in the surge protection device 1A, and connects the other end of the tester to the terminal block screw portion 12. Then, the user performs the two-terminal measurement method using the tester, and reads the voltage between the terminal connector portion 11 and the terminal block screw portion 12. The user determines degradation of the positive side varistor 21 on the basis of the read voltage.

Furthermore, the user connects one end of the tester to the terminal connector portion 11 included in the surge protection device 1A, and connects the other end of the tester to the terminal block screw portion 13. Then, the user performs the two-terminal measurement method by using the tester, and reads the voltage between the terminal connector portion 11 and the terminal block screw portion 13. The user determines degradation of the negative side varistor 22 on the basis of the read voltage.

In addition, the user may calculate the number of surge occurrences on the basis of a degradation state of the positive side varistor 21 or the negative side varistor 22 included in the surge protection device 1A, and may determine the degradation state of the surge protection device 1A on the basis of the calculated number of surge occurrences.

Furthermore, in this configuration of the intercommunication transmitter 200, it is possible to mount the AD converter 31 and the MCU 32 illustrated in FIG. 8 on the surge protection device 1A, and causes the AD converter 31 and the MCU 32 to perform automatic determination on the degradation. In this case, it is also possible to cause the MCU 32 to perform automatic determination on a presumption of the remaining durability count, an estimation of the degradation period in the future, and the purchase period of a replacement of the spare part.

Here, the primary transmitter 100A corresponds to one example of a "first transmitter", the secondary transmitter 100B corresponds to one example of a "second transmitter". Furthermore, the surge protection device 1A corresponds to one example of a "surge protection device".

Here, in the present embodiment, a case in which the surge protection device is not mounted on the secondary transmitter 100B has been described, but the surge protection device may be mounted on the secondary transmitter 100B. Even in that case, there is no need to provide a structure for detecting degradation in the surge protection device that is mounted on the secondary transmitter 100B. In this case, it is conceivable that the degradation of the surge protection device 1A is the same as the degradation of a surge protection device 1B that is mounted on the secondary transmitter 100B. Accordingly, the user detects the degradation of each of the surge protection device 1A and the surge protection device 1B on the basis of the determination result of the degradation of the positive side varistor 21 and the determination result of the degradation of the negative side varistor 22.

The surge protection device 1A that is the first surge protection device includes a signal terminal that corresponds to each of a combination of the terminal block screw portion 12 and the screw 14, and a combination of the terminal block screw portion 13 and the screws 15 and 16. Furthermore, the surge protection device 1A includes a connector 23 that is detachable with respect to the connector component of the primary transmitter 100A corresponding to the first transmitter and that outputs an input signal received from the signal terminal to the connector component. Furthermore, the surge protection device 1A includes the positive side varistor 21 and the negative side varistor 22 that are the surge protection elements each of which absorbs a surge electric current in a case where a surge voltage with respect to the connector component is applied from the signal terminal. Furthermore, the surge protection device 1A includes the terminal connector portion 11 that is connected to the signal terminal via the surge protection element.

### Effects

As described above, even in a case of the use of the intercommunication transmitter 200 that includes the primary transmitter 100A and the secondary transmitter 100B, it is possible to mount the surge protection device 1A on the intercommunication transmitter 200. Furthermore, even in a case of the use of the surge protection device 1A on which the intercommunication transmitter 200 is mounted, it is possible to presume an occurrence period of the degradation and determine the purchase period of the spare part. As a result of this, the user is able to procure the spare part in advance, and is able to replace the surge protection device 1A that is mounted on the intercommunication transmitter 200 in an appropriate period. Therefore, this makes it possible to improve the reliability of the field device.

### System

The flow of the processes, the control procedures, the specific names, and the information containing various kinds of data or parameters indicated in the above specification and drawings can be arbitrarily changed unless otherwise stated.

Furthermore, the components of each unit illustrated in the drawings are only for conceptually illustrating the functions thereof and are not always physically configured as illustrated in the drawings. In other words, the specific shape of a separate or integrated device is not limited to the drawings. Specifically, all or part of the device can be configured by functionally or physically separating or integrating any of the units depending on various loads or use conditions.

Some examples of combinations of the disclosed technical features will be described below.

According to the present invention, it is possible to improve reliability of a transmitter by detecting degradation of a surge protection device.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A surge protection device (1) that is mounted on a transmitter (100), the surge protection device (1) comprising:
a signal terminal (12, 13) to which a cable that sends a signal output from an external device is connected;
a connector (23) that is detachable with respect to a connector component provided in the transmitter (100), and that outputs an input signal received from the signal terminal (13, 15 or 16) to the connector component;
a surge protection element (21, 22) that absorbs a surge electric current in a case where a surge voltage is applied from the signal terminal (12, 13) to the connector component; and
a terminal connector portion (11) that is connected to the signal terminal (12, 13) via the surge protection element (21, 22).

2. The surge protection device (1) according to claim 1, further including a housing (2) that is detachably mounted on the transmitter (100), wherein
the signal terminal (12, 13), the connector (23), and the terminal connector portion (11) are arranged so as to be exposed outside from the housing (2), and
the surge protection element (21, 22) is arranged in an interior portion of the housing (2) or arranged on an outer surface of the housing (2).

3. The surge protection device (1) according to claim 2, wherein, when the housing (2) is mounted on the transmitter (100), the connector (23) is connected to the connector component, and, when the housing (2) is removed from the transmitter (100), the connector (23) is removed from the connector component.

4. The surge protection device (1) according to any one of claims 1 to 3, wherein the signal terminal (12, 13) and the terminal connector portion (11) are connected such that a resistance value of the surge protection element (21, 22) is able to be measured by a terminal measurement method performed by using a tester.

5. The surge protection device (1) according to any one of claims 1 to 4, wherein
the connector component is connected to an internal circuit that is built into the transmitter (100), and
the signal terminal (12, 13) sends the signal output from the external device to the internal circuit via the connector (23) and the connector component.

6. The surge protection device (1) according to any one of claims 1 to 5, wherein
one end of the surge protection element (21, 22) is connected to the signal terminal (12, 13), and the other end of the surge protection element (21, 22) is connected to a grounding wire, and
the terminal connector portion (11) is connected to wiring that is branched off from wiring that connects the surge protection element (21, 22) and the grounding wire.

7. The surge protection device (1) according to any one of claims 1 to 6, wherein the surge protection element (21, 22) includes
a positive side varistor that absorbs a surge electric current generated in a case where a surge voltage on a positive side is applied, and
a negative side varistor that absorbs a surge electric current generated in a case where a surge voltage on a negative side is applied.

8. The surge protection device (1) according to any one of claims 1 to 7, further including a control unit that measures a resistance value of the surge protection element (21, 22) from a leakage electric current flowing between the signal terminal (12, 13) and the terminal connector portion (11), and detects degradation of the surge protection element (21, 22) from the measured resistance value of the surge protection element (21 or 22).

9. The surge protection device (1) according to claim 8, wherein the control unit has in advance information on an amount of change in the resistance value of the surge protection element (21, 22) due to a single surge, and presumes a remaining durability count of the surge protection element (21, 22) based on the measured resistance value of the surge protection element (21, 22) and the amount of change.

10. The surge protection device (1) according to claim 9, wherein the control unit counts the number of surge occurrences, and predicts a degradation period of the surge protection element (21, 22) based on the number of occurrences, operation time, and the remaining durability count.

11. The surge protection device (1) according to claim 10, wherein the control unit determines a purchase period of a spare part of the surge protection element (21, 22) in accordance with the predicted degradation period.

12. A transmitter having the surge protection device of claim 1 mounted thereon.

13. A surge protection system comprising:
a transmitter (100) of claim 12; and
a tester, wherein
the tester includes
a first terminal that is connected to the signal terminal (12, 13) of the surge protection device,
a second terminal that is connected to the terminal connector portion (11) of the surge protection device,
a constant electric current circuit that flows a constant electric current between the first terminal and the second terminal, and
a measurement circuit that measures a resistance value between the first terminal and the second terminal in a case where the constant electric current flows by the constant electric current circuit.

14. An intercommunication transmitter (200) comprising;
a first transmitter (100) and a second transmitter (100) each having the surge protection device (1) of claim 1 mounted thereon, wherein
the first transmitter (100) and the second transmitter (100) are connected by a cable for intercommunication.
